# FASCICULE DE BREVET EUROPEEN

(11) **EP 3 266 703 B1**
(45) Date de publication et mention de la délivrance du brevet: **17.10.2018**
(21) Numéro de dépôt: 17169421.9
(22) Date de dépôt: 04.05.2017
(51) Int. Cl.: B64B 1/14, B64B 1/40, B64B 1/44, H01L 31/056, B64B 1/06, H01L 31/068

(54) **BALLON DIRIGEABLE EQUIPE D'UN GENERATEUR SOLAIRE COMPACT A CONCENTRATION LOCALE UTILISANT DES LIGNES DE CELLULES SOLAIRES BIFACIALES**
LENKBARER BALLON, DER MIT EINEM KOMPAKTEN SOLARGENERATOR MIT LOKALER KONZENTRATION AUSGESTATTET IST, DER REIHEN VON ZWEISEITIGEN SOLARZELLEN VERWENDET
AIRSHIP PROVIDED WITH A LOCAL-CONCENTRATING COMPACT SOLAR GENERATOR USING LINES OF BIFACIAL SOLAR CELLS

(30) Priorité: 08.07.2016 FR 1601064
(43) Date de publication de la demande: 10.01.2018
(73) Titulaire: THALES, 92400 Courbevoie (FR)
(72) Inventeur: DARGENT, Thierry, 06156 CANNES LA BOCCA CEDEX (FR)
(74) Mandataire: Tanguy, Yannick

(56) Documents cités:
- EP-A1- 2 597 031
- WO-A2-2014/028201
- FR-A1- 2 497 927
- FR-A1- 3 015 149
- JP-A- H11 238 900

## Description

La présente invention concerne un ballon dirigeable, équipé d'un générateur solaire compact utilisant des lignes de cellules solaires bifaciales. Un tel ballon dirigeable est connu de FR 3 015 149 A1, qui est considéré comme l'art antérieur le plus proche et décrit les caractéristiques du préambule de la revendication 1.

Le domaine de l'invention concerne les générateurs solaires à concentration de rayonnement solaire, destinés après installation, à alimenter en énergie électrique un ballon dirigeable et rendre ledit ballon autonome d'un point de vue énergétique s'agissant de sa propulsion et de l'alimentation de ses systèmes embarqués à son bord.

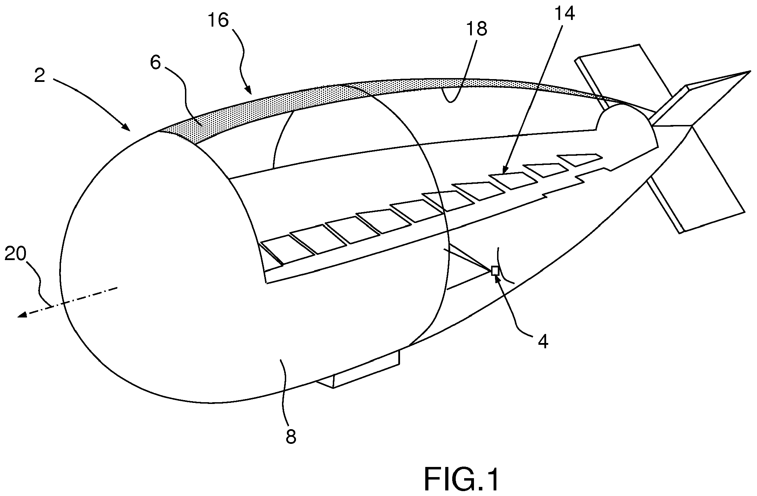

Plus particulièrement, l'invention s'applique à un projet de plateforme stratosphérique autonome en cours de développement, dénommé « Stratobus » et conçu pour garder une position stationnaire en résistant en permanence, c'est-à-dire 24 heures sur 24 heures, aux forces de pression externe exercées par les vents d'altitude. Comme illustré sur la Figure 1 et de manière connue, un ballon stratosphérique 2 de ce type a une grande taille et met en oeuvre un système de propulsion électrique 4 de puissance élevée, c'est-à-dire par exemple un système d'hélices entraînées par un ou plusieurs moteurs électriques, qui utilisent de très grands panneaux solaires 6. Par exemple et typiquement, le ballon a une forme allongée suivant une direction longitudinale et a une enveloppe externe 8 contenu dans un gabarit cylindrique d'environ 100 mètres de long et 30 mètres de diamètre. Une telle taille du ballon 2 correspond à un besoin d'énergie électrique égal à environ une centaine de kilowatts.

Les solutions actuelles de générateurs solaires, proposées pour fournir une telle quantité élevée d'énergie électrique, utilisent comme représenté sur la Figure 1, un panneau solaire 6 équipé de cellules solaires bi- ou mono-faciales et un concentrateur 14 de rayonnement solaire, l'ensemble formant un générateur solaire 16 à concentrateur de rayonnement.

Suivant ces solutions connues et la Figure 1, le panneau solaire 6 du générateur solaire 16 est disposé au sommet 18 du ballon 2 tandis que le concentrateur de rayonnement 14 est disposé et installé à l'intérieur de l'enveloppe externe 8, en étant éloigné de manière significative du sommet 18 de l'enveloppe externe 8. Par exemple, le concentrateur de rayonnement 14 est disposé longitudinalement proche d'un axe central longitudinal 20 du ballon comme illustré sur la Figure 1 ou à un niveau en dessous de l'axe longitudinal en s'éloignant du sommet de l'enveloppe externe 8.

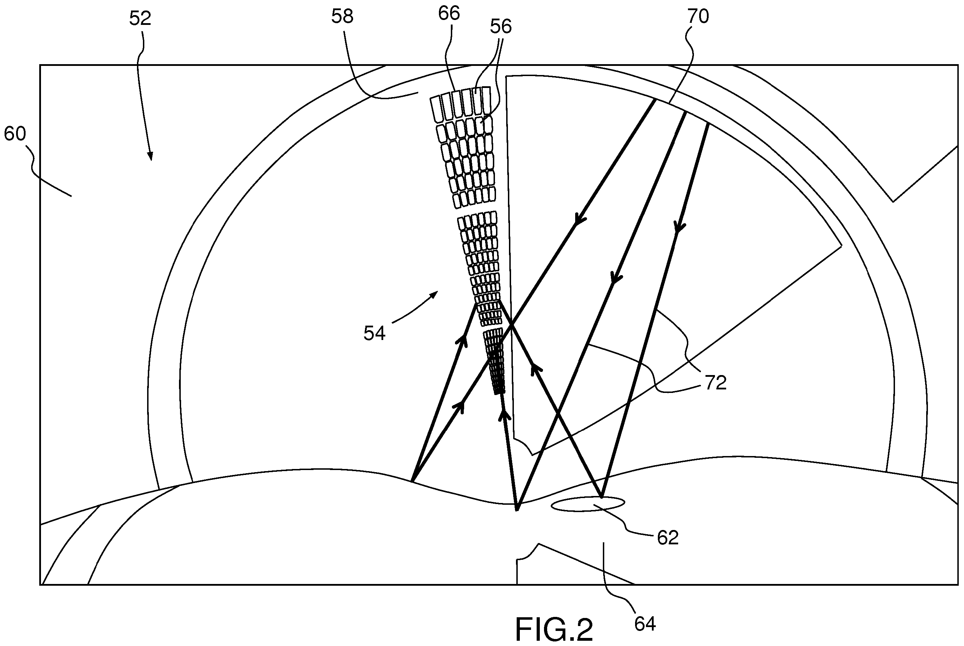

Suivant la Figure 2 et la demande de brevet français, déposée le 15 juillet 2015 sous le numéro de dépôt 1 501486, et intitulée « Ballon équipé d'un générateur solaire à concentration et utilisant un agencement de cellules solaires, optimisé pour alimenter en vol ledit ballon », un ballon 52 à générateur solaire 54 à concentration, vu depuis son intérieur, comporte et utilise des cellules solaires bifaciales 56, disposées au sommet 58 de son enveloppe externe 60. Le générateur solaire 54 comprend un concentrateur 62 de rayonnement solaire, disposé à l'intérieur de l'enveloppe externe 60 et installé de manière souple sur une première zone inférieure 64 de l'enveloppe externe 60 en regard du sommet 58 de la même enveloppe externe 60. L'enveloppe externe 60 comporte vers le sommet 58, de part et d'autres des cellules solaires bifaciales 56 agencées en une bande 66, une deuxième zone transparente 70 pour laisser passer les rayons solaires 72 vers le concentrateur de rayonnement 62.

Cette solution présente les inconvénients suivants. Premièrement, le concentrateur de rayonnement, installé dans et fixé à l'enveloppe externe du ballon, est difficile à réaliser, d'une part en termes de respect d'exigences géométriques de précision de placement dudit concentrateur vis-à-vis des cellules solaires dans une enveloppe externe souple soumise à des déformations, et d'autre part en termes d'intégration dans une enveloppe externe également étanche. Deuxièmement, d'un point de vue de la conception globale du ballon dirigeable, c'est-à-dire au niveau le plus élevé de la conception du système, cette configuration d'un concentrateur de rayonnement implanté à l'intérieur de l'enveloppe externe, couple les contraintes de conception de l'enveloppe externe avec celles de conception du générateur solaire, ce qui complique l'obtention d'une solution simple à mettre en oeuvre et rend le système difficile à tester. Troisièmement, au niveau de la génération de puissance électrique, le système actuel de générateur solaire nécessite une enveloppe externe transparente, au moins sur une zone de sa partie supérieure, ce qui diminue l'efficacité du générateur solaire en raison de l'absorption du rayonnement solaire subie aux traversées des parois de l'enveloppe et limite le refroidissement par rayonnement infrarouge de la face arrière des cellules solaires, un matériau transparent dans le visible ne l'étant pas dans l'infrarouge. De plus, le matériau de l'enveloppe devant être à la fois transparent et très résistant mécaniquement sur une durée de vie longue, c'est-à-dire ici sur au moins cinq ans, des difficultés de réalisation technologique restent à surmonter et viennent s'ajouter. Quatrièmement, le fait de laisser entrer le rayonnement solaire dans le ballon provoque un échauffement interne du ballon qui augmente la pression interne de ce dernier et demande de sur-dimensionner la résistance mécanique de l'enveloppe.

La présente invention vise à surmonter les inconvénients précités.

Le problème technique est de fournir un générateur solaire plus léger, simple à réaliser, plus efficace en terme d'efficacité de fourniture d'énergie électrique délivrée par unité de surface de cellules solaires, avec un minimum d'interaction mécanique et thermique avec l'enveloppe du ballon.

A cet effet, l'invention a pour objet un ballon dirigeable, équipé d'un générateur solaire compact à concentration pour alimenter en énergie électrique ledit ballon en vol à partir du rayonnement solaire, le ballon dirigeable comprenant une enveloppe externe, un gaz porteur contenu dans l'enveloppe externe, et un générateur solaire compact à concentration, l'enveloppe externe ayant une surface externe fermée de forme allongée le long d'un axe central longitudinal prédéterminé. Le générateur solaire compact comporte :
.- un premier ensemble d'au moins une ligne de cellules solaires photovoltaïques bifaciales, disposée au dessus et à une hauteur prédéterminée h d'une portion compacte de sommet de la surface externe, dans lequel chaque ligne de cellules solaires bifaciales est configurée pour suivre en surplomb un chemin longitudinal, tracé sur la portion compacte de sommet de ladite surface externe et contenu dans un plan de projection radiale contenant l'axe central longitudinal de la surface externe; et
.- un concentrateur de rayonnement solaire pour faire converger des rayons solaires vers des faces arrières des cellules solaires bifaciales du premier ensemble.

Le ballon dirigeable est caractérisé en ce que :
.- le concentrateur de rayonnement solaire est un deuxième ensemble d'au moins un concentrateur local de rayonnement solaire, dans lequel chaque concentrateur local est apparié à une ligne correspondante de cellules solaires, et comporte un réflecteur dont une première face réfléchissante a une surface de forme convexe adaptée pour faire converger du rayonnement solaire vers les faces arrière des cellules solaires de la ligne appariée, et dont une deuxième face concave, arrière de la première face convexe, est fixée a la surface externe de l'enveloppe externe en suivant le chemin longitudinal surplombé par la ligne correspondante des cellules solaires, et
.- les première et deuxième faces des concentrateurs locaux de rayonnement solaire sont dimensionnées et disposées entre elles de sorte à laisser les concentrateurs séparées ou adjacents.

Suivant des modes particuliers de réalisation, le ballon, équipé d'un générateur solaire à concentration, comprend l'une ou plusieurs des caractéristiques suivantes :
.- la géométrie des lignes des cellules solaires et des faces des concentrateurs locaux est ajustée de façon à assurer un flux solaire constant et de même intensité indépendant de la position de la cellule solaire photovoltaïque sur la portion de surface externe ;
.- chaque cellule bifaciale a une face avant et une face arrière, et les cellules bifaciales des lignes du premier ensemble sont disposées en termes de positionnement et d'orientation par rapport à la portion de surface externe du ballon à laquelle les cellules sont fixés de sorte que les normales des faces avant de toutes les cellules solaires pointent vers une même direction d'éclairement prédéterminée par rapport au ballon ;
.- la surface de la première face convexe réfléchissante de chaque concentrateur local comprend une première bande masquée par les cellules solaires de la ligne associée, des deuxième et troisième bandes actives participant à la concentration du rayonnement solaire, les première et deuxième bandes actives étant constituées en un matériau réfléchissant vis-à-vis du rayonnement contenu dans les bandes de fréquences intervenant dans la conversion photovoltaïque, et la première bande masquée étant constituée en un matériau réfléchissant vis-à-vis du rayonnement thermique émis par les cellules photovoltaïques lorsqu'elles sont actives ;
.- la surface de la première face convexe réfléchissante de chaque concentrateur local est constituée intégralement en un matériau à la fois réfléchissant vis-à-vis du rayonnement contenu dans les bandes de fréquences intervenant dans la conversion photovoltaïque, et réfléchissant vis-à-vis du rayonnement thermique émis par les cellules photovoltaïques et le soleil ;
.- chaque ligne de cellules solaires du premier ensemble est fixé à la portion de surface externe de l'enveloppe externe au travers du concentrateur local associé et d'un pilotis de poteaux, interposés et fixés entre la ligne des cellules photovoltaïques et le concentrateur local apparié, le matériau constituant les poteaux étant rigide, électriquement isolant et peu absorbant vis-à-vis rayonnement solaire ;
.- les surfaces des premières faces convexes réfléchissantes ont des contours de coupe transversale longitudinale dont la forme est une portion de conique ou une courbe approchant une portion de conique ;
.- les surfaces des premières faces convexes réfléchissantes ont des contours de coupe transversale longitudinale dont la forme est une succession d'un nombre entier impair N de segments approchant une portion de conique, le nombre entier impair N de segments étant compris de préférence parmi les entiers 3, 5 et 7 ;
.- le rapport de la hauteur de surplomb h des lignes de cellules solaires sur la distance r séparant la portion de surface externe de l'axe central longitudinal de la surface externe est inférieure ou égale à 1/15, de préférence inférieure ou égal à 1/30 ;
.- le générateur solaire compact comprend un nombre entier NL de lignes de cellules solaires et de concentrateurs locaux, et chaque concentrateur local est décomposé en une séquence longitudinal d'un nombre entier T, supérieur ou égal à 2, de tronçons longitudinaux de concentrateur local, appariés soit dans un premier cas à une ligne de droite de cellules solaires de même niveau radial par rapport à l'axe longitudinal, ou dans un deuxième cas à une ligne de cellules solaires segmentée en différents niveaux radiaux par rapport à l'axe longitudinal ;
.- chaque tronçon longitudinal comporte un réflecteur élémentaire dont une première face réfléchissante élémentaire a une surface de forme convexe adaptée pour faire converger du rayonnement solaire vers les faces arrière des cellules solaires de la ligne appariée de même niveau longitudinal et dont une deuxième face élémentaire, arrière et concave, est fixée a la portion de surface externe de l'enveloppe externe en suivant le chemin longitudinal surplombé par la ligne appariée des cellules solaires ;
.- la géométrie des lignes des cellules solaires et des faces des tronçons longitudinaux des concentrateurs locaux est ajustée de façon à assurer un flux solaire constant et de même intensité indépendant de la position de la cellule solaire photovoltaïque sur la portion de surface externe ;
.- la surface de la première face réfléchissante élémentaire de chaque tronçon de concentrateur local comprend une première bande élémentaire masquée par les cellules solaires de même niveau longitudinal de la ligne appariée, des deuxième et troisième bandes élémentaires actives participant à la concentration du rayonnement solaire, les première et deuxième bandes élémentaires actives étant constituées en un matériau réfléchissant vis-à-vis du rayonnement contenu dans les bandes de fréquences intervenant dans la conversion photovoltaïque, et la première bande élémentaire masquée étant constituée en un matériau réfléchissant vis-à-vis du rayonnement thermique émis par les cellules photovoltaïques lorsqu'elles sont actives ;
.- les surfaces des premières faces élémentaires convexes réfléchissantes ont des contours de coupe transversale longitudinale dont la forme est une portion de conique ou une courbe approchant une portion de conique ;
.- les surfaces des premières faces élémentaires convexes réfléchissantes ont des contours de coupe transversale longitudinale dont la forme est une succession d'un nombre entier impair N de segments approchant une portion de conique, le nombre entier impair N de segments étant compris de préférence parmi les entiers 3, 5 et 7.

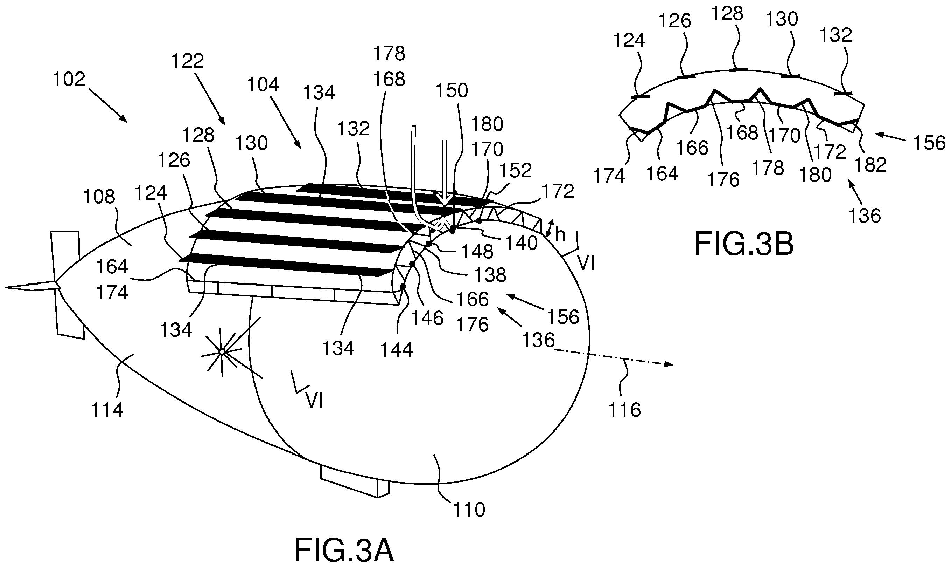

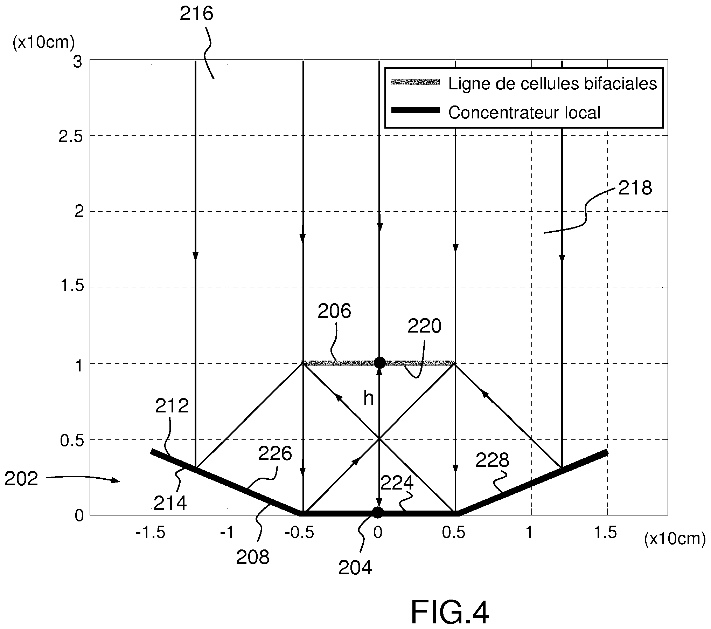

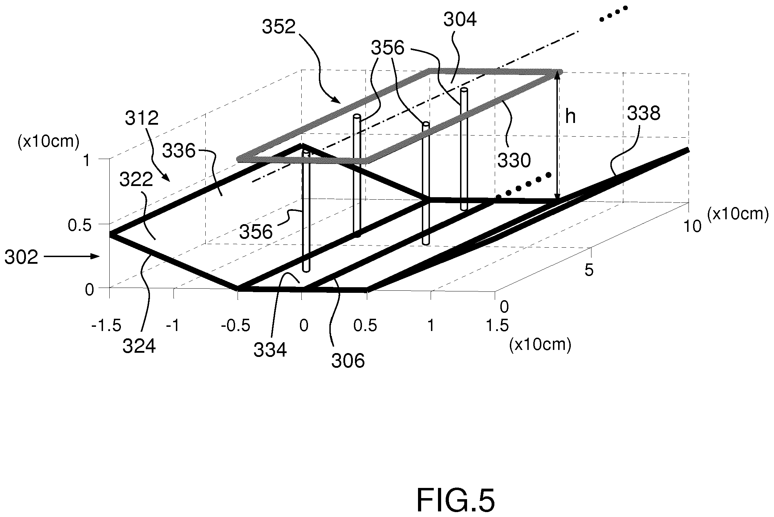

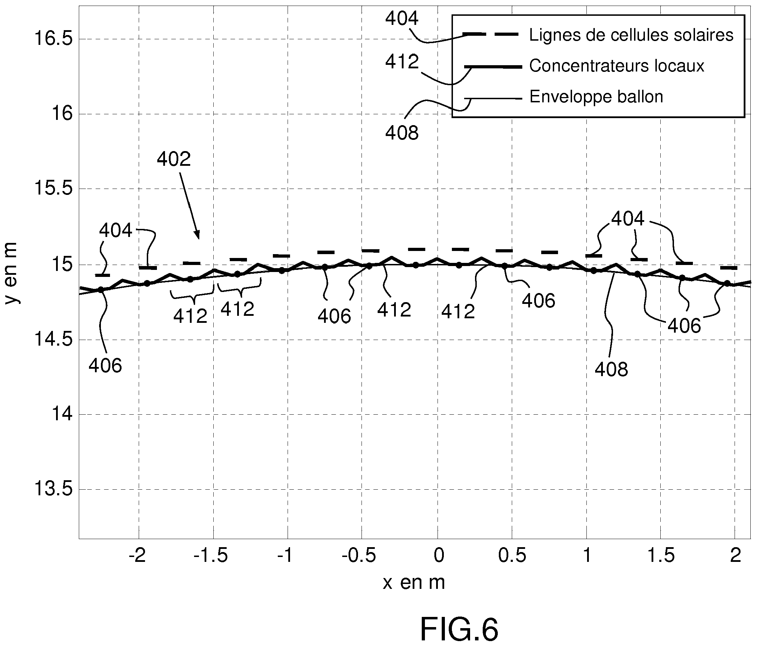

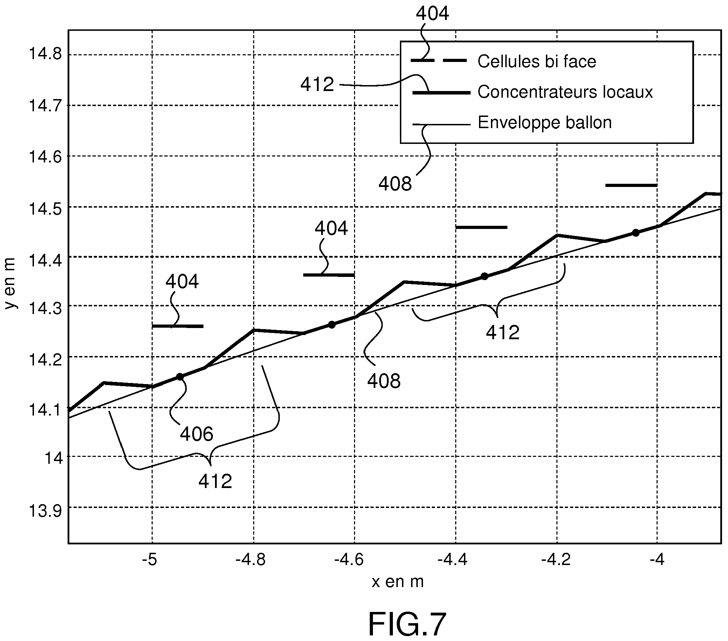

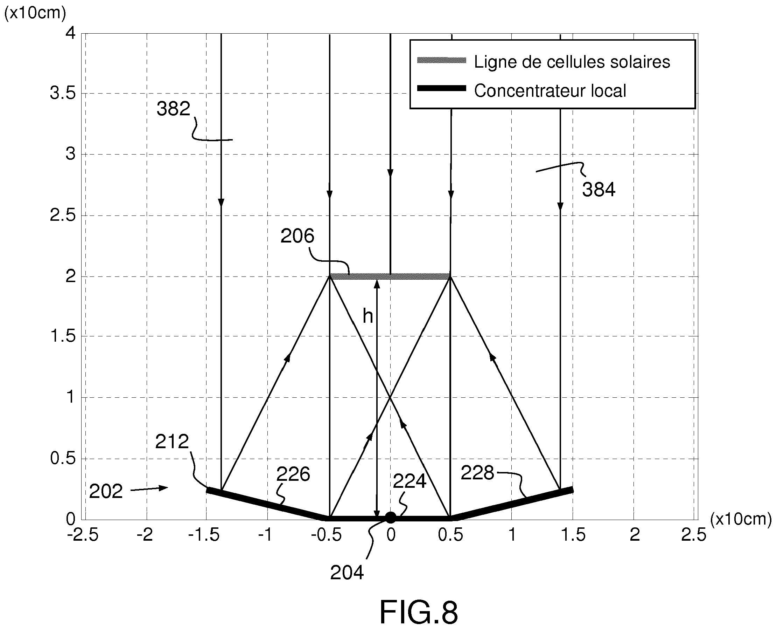

L'invention sera mieux comprise à la lecture de la description de plusieurs formes de réalisation qui va suivre, donnée uniquement à titre d'exemple et faite en se référant aux dessins sur lesquels :
.- la Figure 1 est une vue extérieure d'un ballon dirigeable, équipé de et intégrant un générateur solaire à concentration de rayonnement solaire selon l'état de la technique ;
.- la Figure 2 est une vue intérieure du ballon dirigeable suivant l'état de la technique de la Figure 1, prise depuis l'intérieur de l'enveloppe externe du ballon ;
.- la Figure 3A est une vue en perspective d'un ballon dirigeable, équipé de et intégrant un générateur solaire compact à concentration de rayonnement selon un mode de réalisation générale de l'invention ;
.- la Figure 3B est une vue de face partielle de face, perpendiculaire et de bout par rapport à l'axe longitudinal du ballon, du générateur solaire intégré au ballon dirigeable de la Figure 3A ;
.- la Figure 4 est une vue de coupe transversale schématique d'un premier mode de réalisation particulier d'un concentrateur local du générateur solaire compact de la Figure 3, apparié à sa ligne de cellules solaires, dans le cas où la portion de surface externe recouverte par le générateur solaire compact peut être assimilé à une unique tuile de cylindre d'extension longitudinale, et dans une configuration de placement au sommet de l'enveloppe du ballon ;
.- la Figure 5 est une vue schématique tridimensionnelle partielle d'un deuxième mode de réalisation particulier d'un concentrateur local du générateur solaire compact de la Figure 3, découpé en un nombre T de tronçons longitudinaux, apparié à sa ligne de cellules solaires, dans le cas où la portion de surface externe recouverte par le générateur solaire compact peut être assimilé à une succession longitudinale de T tuiles de cylindres dont les diamètres peuvent varier, un seul tronçon longitudinal étant illustré dans une configuration de placement au sommet de l'enveloppe du ballon;
.- la Figure 6 est une vue partielle en coupe transversale d'un générateur solaire compact selon l'invention de la Figure 3A suivant le plan de coupe VI-VI de la Figure 3A, dans lequel les concentrateurs locaux sont définis suivant l'un des motifs de modes de réalisation des Figures 4 et 5, et dans lequel les inclinaisons des faces des cellules solaires et des faces réfléchissantes de renvoi des concentrateurs locaux par rapport aux plans locaux de fixation à l'enveloppe externe sont ajustées en fonction de leur emplacement pour optimiser l'efficacité de concentration du générateur solaire compact ;
.- la Figure 7 est une vue partielle en coupe transversale du même générateur solaire compact que celui de la Figure 6 dans une zone plus éloignée horizontalement du haut du ballon et à une échelle plus grande ;
.- la Figure 8 est une vue de coupe transversale schématique d'une variante du premier mode de réalisation des concentrateurs locaux suivant la Figure 4 dans laquelle la hauteur h de surplomb des lignes de cellules solaire, et en conséquence l'épaisseur du générateur solaire est modifiée pour augmenter l'efficacité de l'ensemble des concentrateurs locaux.

Le concept sous-jacent de l'invention consiste à remplacer le générateur solaire selon l'état de l'art dont le concentrateur solaire global est intégré à l'intérieur de l'enveloppe externe du ballon dirigeable par un générateur solaire compact, à concentration locale de rayonnement, de faible épaisseur au regard du diamètre du ballon, dans lequel un ensemble de concentrateurs locaux est disposé à l'extérieur et au sommet de l'enveloppe externe du ballon. Les concentrateurs locaux sont situés au-dessous et au plus près des cellules bifaciales, épousent et suivent la surface du ballon tout en assurant une concentration biface efficace du rayonnement solaire vers les cellules solaires afin de maximiser la performance énergétique du panneau solaire global.

Ainsi, cette solution de générateur solaire compact à concentration locale, installée intégralement à l'extérieur du ballon, permet de remédier aux problèmes techniques précités que présentent les systèmes actuels de générateur solaire, sans pour autant perturber l'aérodynamique et la thermique du ballon en raison de la faible épaisseur du générateur solaire par rapport au diamètre du ballon et en raison de l'absence de contact direct des parties chaudes du générateur solaire, c'est-à-dire les cellules solaires, avec l'enveloppe du ballon.

Suivant la Figure 3A et un mode de réalisation général de l'invention, un ballon dirigeable 102 est équipé d'un générateur solaire compact 104 à concentration locale pour alimenter en énergie électrique ledit ballon 102 en vol à partir d'un rayonnement solaire.

Le ballon dirigeable 102 comprend une enveloppe externe 108, un gaz porteur 110 contenu dans l'enveloppe externe 108, et le générateur solaire compact 104 à concentration locale de rayonnement solaire.

L'enveloppe externe 108 comporte une surface externe 114 fermée de forme allongée le long d'un axe central longitudinal 116 prédéterminé.

Suivant les Figures 3A et 3B, le générateur solaire compact comporte un premier ensemble 122 d'au moins une ligne 124, 126, 128, 130, 132 de cellules solaires photovoltaïques bifaciales 134, et un concentrateur 136 de rayonnement solaire pour faire converger des rayons solaires vers des faces arrière des cellules solaires bifaciales 134 du premier ensemble 122.

Le premier ensemble 122 des lignes 124, 126, 128, 130, 132 de cellules solaires 134 est disposé au-dessus et à une hauteur prédéterminée h d'une portion compacte 138 de sommet 140 de la surface externe 114, dans lequel chaque ligne 124, 126, 128, 130, 132 de cellules solaires bifaciales 134 est configurée pour suivre respectivement en surplomb un chemin longitudinal 144, 146, 148, 150, 152, tracé sur la portion compacte 138 de sommet 140 de ladite surface externe 114 et contenu dans un plan de projection radiale correspondant, non représenté sur la Figure 3A, contenant l'axe longitudinal 116 de la surface externe 114.

Suivant les Figures 3A et 3B, le concentrateur 136 de rayonnement solaire est un deuxième ensemble 156 d'au moins un concentrateur local 164, 166, 168, 170, 172, de rayonnement solaire, dans lequel chaque concentrateur local 164, 166, 168, 170, 172 est apparié à une ligne correspondante 124, 126, 128, 130, 132 de cellules solaires, en ayant un réflecteur 174, 176, 178, 180, 182 dont une première face réfléchissante a une surface de forme plane ou concave ou convexe, ici convexe sur la Figure, adaptée pour faire converger du rayonnement solaire vers les faces arrière des cellules solaires de la ligne correspondante 124, 126, 128, 130, 132 et dont une deuxième face plane ou concave, ici concave sur la Figure, arrière de la première face convexe, est fixée a la surface externe de l'enveloppe externe en suivant le chemin longitudinal de l'enveloppe du ballon surplombé par la ligne correspondante 124, 126, 128, 130, 132 des cellules solaires.

Les première et deuxième faces des concentrateurs locaux 164, 166, 168, 170, 172 de rayonnement solaire sont dimensionnées et disposées entre elles de sorte à laisser les concentrateurs locaux 164, 166, 168, 170, 172 séparées ou adjacents.

De manière générale, la géométrie des lignes des cellules solaires et des faces des concentrateurs locaux est ajustée de façon à assurer un flux solaire constant et de même intensité indépendant de la position de la cellule solaire photovoltaïque sur la portion de surface externe.

La géométrie peut être définie notamment par la forme et les dimensions des faces réfléchissantes des concentrateurs locaux, mais également par des inclinaisons des faces réfléchissantes d'un concentrateur local par rapport au plan local tangent de fixation du concentrateur local à l'enveloppe externe.

De manière générale, la surface de la première face convexe réfléchissante de chaque concentrateur local comprend une première bande de surface masquée par les cellules solaires de la ligne associée, des deuxième et troisième bandes de surfaces actives participant à la concentration du rayonnement solaire. Les deuxième et troisième bandes de surfaces actives sont constituées en un matériau réfléchissant vis-à-vis du rayonnement contenu dans les bandes de fréquences intervenant dans la conversion photovoltaïque et en infrarouge pour le rayonnement thermique. La première bande de surface masquée est constituée en un matériau réfléchissant vis-à-vis du rayonnement thermique émis par les cellules photovoltaïques lorsqu'elles sont actives.

De manière particulière et préférée, la surface de la première face convexe réfléchissante de chaque concentrateur local est constituée intégralement en un matériau à la fois réfléchissant vis-à-vis du rayonnement contenu dans les bandes de fréquences intervenant dans la conversion photovoltaïque, et réfléchissant vis-à-vis du rayonnement thermique émis par les cellules photovoltaïques et le soleil. Par exemple, les trois surfaces de la première face convexe sont constituées en un même matériau plastique avec argenture (dépôt d'un film d'argent).

De manière générale, les surfaces des premières faces convexes réfléchissantes ont des contours de coupe transversale longitudinale dont la forme est une portion de conique ou une courbe approchant une portion de conique.

De manière générale, chaque ligne de cellules solaires du premier ensemble est fixé à la portion de surface externe de l'enveloppe externe au travers du concentrateur local associé et d'un pilotis de poteaux, non représentés sur les Figure 3A et 3B, interposés et fixés entre la ligne des cellules photovoltaïques et le concentrateur local apparié. Le matériau constituant les poteaux est rigide, électriquement isolant et peu absorbant vis-à-vis rayonnement solaire.

Ainsi et à l'inverse du générateur solaire de l'état de l'art décrit sur les Figures 1 et 2, l'enveloppe externe 108 du ballon 102 ne requiert pas l'existence d'une zone transparente pour laisser passer les rayons de soleil et leur permettre d'atteindre un concentrateur de rayonnement disposé à l'intérieur de ladite enveloppe.

En conséquence et suivant la Figure 1, les rayons du soleil 192, 194 ne traversant pas l'enveloppe externe 108 du ballon, il n'y a pas d'atténuation du flux solaire incident, ni réchauffement interne du ballon. De même, le refroidissement radiatif de la face arrière de la cellule bifaciale se trouve facilitée et se fait sans traversée de la paroi de l'enveloppe du ballon, opaque à l'infrarouge.

De plus, les cellules solaires bifaciales étant découplées mécaniquement et thermiquement de l'enveloppe externe du ballon, elles n'échauffent pas directement par conduction ou par rayonnement ledit ballon.

En outre, le générateur solaire compact à concentration locale étant intégralement externe au ballon, il peut être fabriqué et testé indépendamment du sous-système, formé par l'enveloppe, et installé ultérieurement lors de l'intégration du ballon dirigeable.

Suivant la Figure 4 et un exemple schématique d'une première forme de réalisation d'un concentrateur local 202, le concentrateur local 202, vu en coupe, est supposé ici être situé au sommet du ballon, et suivre sur la portion de surface externe de l'enveloppe un chemin rectiligne 204, surplombé par une ligne 206 appariée correspondante de cellules solaires bifaciales. Ici la courbure d'une bande de la surface externe du ballon, large d'une dizaine de centimètres, située autour et au voisinage du chemin rectiligne 204 est supposé proche de celle d'un plan. L'éclairement solaire direct des cellules de la ligne 206 est supposé provenir verticalement du haut de la Figure 4, perpendiculairement au plan tangent au chemin 204 au sommet du ballon.

Le concentrateur local 202 comporte un réflecteur 208 ayant une première face réfléchissante 212 et une deuxième face arrière 214.

La première face réfléchissante 212 a une forme convexe adaptée pour faire converger le rayonnement solaire de deux faisceaux incidents 216, 218 vers les faces arrière 220 des cellules solaires bifaciales de la ligne 206.

La deuxième face arrière 214 a une face concave, fixée en suivant le chemin longitudinal 204.

La première face réfléchissante 212 comprend une première bande 224 de surface, ici plane, masquée par les cellules solaires de la ligne 206 associée, des deuxième et troisième bandes 226, 228, ici planes, de surfaces actives participant à la concentration du rayonnement solaire, ici les faisceau incidents 216, 218 vers les faces arrière des cellules de la ligne 206.

En variante, les surfaces des premières faces convexes réfléchissantes ont des contours de coupe transversale longitudinale dont la forme est une succession d'un nombre entier impair N supérieur ou égal à 5, de segments approchant une portion de conique.

De préférence, le nombre entier N de segments est compris de préférence parmi les entiers 3, 5 et 7.

Le concentrateur local 202, de par sa forme simple en une succession de miroirs plan segmentés, peut être réalisé des clinquants métalliques, par exemple en aluminium, ou tout autre matériau permettant de réaliser un miroir du rayonnement solaire au moins dans la bande de fréquences actives pour la conversion photovoltaïque et dans la bande du rayonnement thermique.

S'agissant de la première bande masquée 224, elle n'intervient pas dans la concentration du rayonnement photovoltaïque, et il peut être suffisant que le matériau la constituant soit apte à réfléchir le rayonnement thermique émis par les cellules solaires bifaciales de conversion photovoltaïque. En effet, les cellules solaires bifaciales émettent un flux thermique intense vers l'enveloppe externe et la première bande masquée 224 du réflecteur 212 de par ses propriétés thermiques permet de réfléchir le flux thermique intense vers l'extérieur du ballon.

Suivant la Figure 4 et à titre d'exemple, la largeur d'une cellule photovoltaïque de la ligne 206 est égale à 10cm tandis que la hauteur h de surplomb par rapport au chemin rectiligne 204 suivi le long de la portion de surface externe est égale à 10 cm. Les largeurs des pans de miroir formés par les première, deuxième et troisième bandes sont chacune égales à 10 cm. Les inclinaisons des deuxième et troisième bandes sont ajustées par rapport à la première bande de sorte à maximiser le facteur de concentration qui est ici égal à 2,41, le facteur de concentration étant défini comme le rapport de la somme des flux solaires reçus par la face avant et la face arrière de la cellule solaire bifaciale sur le flux solaire reçu par la face avant seule.

Il est à remarquer que la forme d'une paire ligne de cellules solaire - concentrateur local, ayant le même motif que la paire ligne 204 - concentrateur local 202 et éloigné angulairement de celle-ci d'un angle prédéterminé a, et optimisant la fourniture d'énergie électrique des cellules solaire de sa ligne, est obtenu en faisant pivoter solidairement la paire ligne 204 de cellules solaires - concentrateur local 202 autour de l'axe médian longitudinal de la première bande de l'angle prédéterminé a, la direction d'éclairement direct solaire restant inchangée c'est à dire verticale sur la Figure 4, puis à incliner les faces de la ligne 204 autour de leur axe médian longitudinal commun de façon à aligner les normales des faces avant des cellules avec la direction prédéterminée d'éclairement solaire, et ensuite a ajuster les inclinaisons des deuxième et troisième bandes par rapport à la première bande de façon à maximiser le renvoi du rayonnement solaire sur les faces arrière des cellules solaires de ligne 204 dont l'inclinaison a été précédemment ajustée.

Suivant la Figure 5 et un exemple schématique d'une deuxième forme de réalisation d'un concentrateur local 302, supposé ici être situé au sommet de l'enveloppe externe du ballon, le concentrateur local 302 est décomposé en une séquence longitudinale d'un nombre entier T, supérieur ou égal à 2, de tronçons longitudinaux de concentrateur local, appariés soit dans un premier cas à une ligne droite de cellules solaires de même niveau radial, ou dans un deuxième cas à une ligne de cellules solaires segmentée en différents niveaux radiaux par rapport à l'axe longitudinal en fonction du niveau longitudinal.

Le premier cas correspond à l'instar de la Figure 4 à une portion de surface externe du ballon recouverte par le générateur solaire compact, assimilable à une unique tuile de cylindre d'extension longitudinale.

Le deuxième cas correspond à une portion de surface externe du ballon recouverte par le générateur solaire compact, assimilable à une succession longitudinale de T tuiles de cylindres dont les diamètres sont différents et varient en fonction du niveau longitudinal.

La ligne des cellules solaires, appariée au concentrateur local 302, est désignée par la référence numérique 304.

Le concentrateur local 302 est supposé ici suivre sur la portion de surface externe de l'enveloppe, un chemin 306 dont le niveau radial est constant ou varie faiblement par palier de longueur identique à celle d'une tuile, le chemin étant surplombé à une hauteur constante h par la ligne 304 correspondante de cellules solaires. Ici la courbure d'une bande de la surface externe du ballon, large d'une dizaine de centimètres, située autour et au voisinage du chemin rectiligne 304 est supposée proche de celle d'un plan.

Suivant la Figure 5, un seul tronçon 312 parmi les T tronçons du concentrateur local 302 est illustré. Le tronçon 312 partage un même motif avec les autres tronçons du concentrateur local, et avec les tronçons des autres concentrateurs locaux. La géométrie du motif est inchangée dans le premier cas de portion de surface externe recouverte et varie dans le deuxième cas en fonction du diamètre de la tuile recouverte parmi les T tuiles.

Le tronçon 312 de concentrateur local comporte un réflecteur élémentaire ayant une première face élémentaire réfléchissante 322 et une deuxième face arrière élémentaire 324.

La première face réfléchissante élémentaire 322 a une forme convexe adaptée pour faire converger le rayonnement solaire de deux faisceaux incidents, non représentés sur la Figure 5, vers les faces arrière 330 des cellules solaires bifaciales de la ligne 304 situées au même niveau longitudinal.

La deuxième face élémentaire arrière 324 a une face concave, fixée à la portion de la surface externe de l'enveloppe externe en suivant le chemin longitudinal 306.

La première face réfléchissante élémentaire 322 comprend une première bande élémentaire 334 de surface, ici plane, masquée par les cellules solaires de la ligne 304 associée, des deuxième et troisième bandes élémentaires 336, 338, ici planes, de surfaces actives participant à la concentration du rayonnement solaire vers les faces arrière des cellules de la ligne 304.

En variante, les surfaces des premières faces élémentaires convexes réfléchissantes ont des contours de coupe transversale longitudinale dont la forme est une succession d'un nombre entier impair N supérieur ou égal à 5, de segments approchant une portion de conique.

De préférence, le nombre entier N de segments est compris de préférence parmi les entiers 3, 5 et 7.

Les T tronçons longitudinaux du concentrateur local 302, de par leur forme simple en une succession de miroirs plan élémentaires segmentés, peuvent être réalisé par des clinquants métalliques, par exemple en aluminium, ou tout autre matériau permettant de réaliser un miroir du rayonnement solaire au moins dans la bande de fréquences actives pour la conversion photovoltaïque.

S'agissant de la première bande élémentaire masquée 334, elle n'intervient pas dans la concentration du rayonnement photovoltaïque, et il peut être suffisant que le matériau la constituant soit apte à réfléchir le rayonnement thermique émis par les cellules solaires bifaciales de conversion photovoltaïque. En effet les cellules solaires bifaciales émettent un flux thermique intense vers l'enveloppe externe et la première bande élémentaire masquée 334 du réflecteur 322 de par ses propriétés thermiques permet de réfléchir le flux thermique intense vers l'extérieur du ballon.

Suivant la Figure 5, la largeur d'une cellule photovoltaïque de la ligne 304 est égale à 10 cm tandis que la hauteur h de surplomb par rapport au chemin rectiligne 306 suivi le long de la portion de surface externe est égale à 10 cm. Les largeurs des pans de miroir formés par les première, deuxième et troisième bandes élémentaires sont chacune égales à 10 cm, leur longueur commune étant ici égale à 1 mètre. Les inclinaisons des deuxième et troisième bandes élémentaires sont ajustées par rapport à la première bande élémentaire de sorte à maximiser le facteur de concentration.

Suivant la Figure 5, la ligne de cellules solaires 304, appariée au concentrateur local 302, est fixée à la portion de surface externe de l'enveloppe externe au travers de chaque tronçon du concentrateur local 302, et d'un pilotis 352 de poteaux 356, interposés et fixés entre la ligne 304 des cellules solaires photovoltaïques et les T tronçons du concentrateur local apparié. Le matériau constituant les poteaux est mécaniquement rigide, électriquement isolant et peu absorbant vis-à-vis rayonnement solaire.

Ici, seuls quatre poteaux 356 du pilotis sont représentés, fixant la ligne 304 des cellules solaire au tronçon 312 du concentrateur local 302.

Le tronçonnage de chaque concentrateur local du deuxième ensemble en T tronçons, ayant un motif indépendant du concentrateur local et du niveau longitudinal d'assemblage du tronçon, en plus de simplifier le procédé de fabrication et d'assemblage du concentrateur et son intégration dans le générateur solaire, permet de maximiser le renvoi du rayonnement solaire vers les cellules solaires du premier ensemble en ajustant les dimensions et la forme des tronçons en fonction de leur emplacement longitudinal et de la position radiale des concentrateurs locaux dans lequel ils sont intégrés.

En variante, des tronçons de concentrateurs locaux adjacents entre eux et de même niveau longitudinal peuvent être regroupés et intégrés sur des panneaux plans si la courbure de la portion de surface externe au niveau longitudinal considéré le permet.

Suivant la Figure 6 et une configuration géométrique particulière d'installation, un générateur solaire compact 402 du type de celui défini dans les Figures 3A et 3B et ayant des concentrateurs locaux du type de celui de la Figure 4 ou des tronçons de concentrateurs du type de celui de la Figure 5, comprend ici quinze lignes 404 de cellules solaires surplombant respectivement quinze segments 406 de génératrices différentes d'une portion d'une surface cylindrique 408 ayant la forme d'une tuile. La surface cylindrique est ici un cylindre de rayon égal à 15 mètres et les segments 406, formant des chemins rectilignes de la portion 408 de surface externe du ballon et représentés de bout sur la Figure 6 par des points, sont mutuellement parallèles. Chaque ligne 404 est apparié à un concentrateur local différent 412, fixé sur la portion 408 de surface externe et ayant un réflecteur 414 à trois miroirs plan segmentés. A l'instar des Figures 4 et 5, chaque ligne 404 de cellules solaires surplombe son chemin 406 associé et le pan de miroir médian du réflecteur du concentrateur local apparié d'une hauteur h constante par rapport au chemin associé.

Les dimensions et la forme de chaque concentrateur ont été ajustées pour assurer un renvoi optimal du rayonnement solaire vers les cellules bifaciales, les inclinaisons des faces des cellules ayant été au préalable ajustées a rendre parallèle leur normale à une direction prédéterminée par rapport au ballon, ici la verticale sur la Figure 6.

Suivant la Figure 7 et afin de mettre mieux en évidence les ajustements des dimensions, formes et inclinaisons des cellules solaires et des concentrateurs locaux par rapport à l'enveloppe du ballon, une vue des cellules solaires et des concentrateurs locaux correspondants, similaire à celle de la Figure 6 mais avec un grossissement plus élevé, est fournie dans laquelle la zone d'enveloppe de support des cellules solaires et des concentrateurs locaux représentés est éloignée horizontalement de la ligne de crête du haut du ballon d'une distance algébrique, noté x, variant entre - 3,6 mètres et -5,2 mètres.

Suivant la Figure 8 et une variante dimensionnelle du premier mode de réalisation des concentrateurs locaux 202 de la Figure 4, la hauteur h de surplomb des lignes de cellules solaire, et en conséquence l'épaisseur du générateur solaire est modifiée pour augmenter l'efficacité de l'ensemble des concentrateurs locaux. Il apparait sur la Figure 8 qu'en augmentant la hauteur h de surplomb de la ligne 206 de cellules solaires et en ajustant l'inclinaison des deuxième et troisième bandes 226, 228 par rapport à la première bande masquée 204, la largeur des faisceaux incidents 382, 384 renvoyés par le réflecteur 212 sur les faces arrière des cellules est augmentée, et qu'en conséquence l'efficacité du concentrateur local 202 est augmentée.

Ainsi en ajustant la hauteur de surplomb h, c'est dire l'épaisseur du générateur solaire, il lest possible d'optimiser l'efficacité du deuxième ensemble de concentrateur locaux et en conséquence l'épaisseur du générateur solaire compact.

De multiples variantes des concentrateurs peuvent être utilisées dans lesquelles la taille des concentrateurs locaux ainsi que leur forme sont d'abord ajustées pour optimiser le facteur de concentration à une valeur souhaitée. Les formes des concentrateurs sont ensuite projetées et ré optimisées localement pour maximiser le renvoi de flux solaire vers les cellules solaires, en utilisant un code de calcul d'optique comme par exemple « codeV ». Comme il a été vu ci-dessus, les formes les plus simples peuvent être des miroirs plan, segmentés en plusieurs plans pour une plus grande facilité de réalisation mais peuvent être également des formes coniques ou assimilées si nécessaire.

De manière générale, le rapport de la hauteur de surplomb h des lignes de cellules solaires sur la distance r séparant la portion de surface externe de l'axe central longitudinal de la surface externe est inférieur ou égale à 1/30.

Par exemple, la hauteur de surplomb sera comprise entre 0,1 et 0,2 mètre pour un rayon de ballon de 15 mètres par rapport à l'axe longitudinal, ce qui correspond à un rapport compris entre 1/50 et 1/75.

De manière générale, le ballon stratosphérique décrit ci-dessus peut être remplacé par n'importe quel autre type de ballon évoluant dans d'autres couches de l'atmosphère, en conservant à l'identique les caractéristiques de l'invention.

## Revendications

1. Ballon dirigeable équipé d'un générateur solaire compact à concentration pour alimenter en énergie électrique ledit ballon en vol à partir du rayonnement solaire,
le ballon dirigeable comprenant une enveloppe externe (108), un gaz porteur contenu dans l'enveloppe externe (108), et un générateur solaire compact (104) à concentration,
l'enveloppe externe (108) ayant une surface externe (114) fermée de forme allongée le long d'un axe central longitudinal (116) prédéterminé,
le générateur solaire compact (104) comportant
un premier ensemble (122) d'au moins une ligne (124, 126, 128, 130, 132 ; 206 ; 304) de cellules solaires photovoltaïques bifaciales (134), disposée au dessus et à une hauteur prédéterminée h d'une portion compacte (138) de sommet (140) de la surface externe (114), dans lequel chaque ligne (124, 126, 128, 130, 132 ; 206 ; 304) de cellules solaires bifaciales est configurée pour suivre en surplomb un chemin longitudinal (144, 146, 148, 150, 152 ; 204 ; 306), tracé sur la portion compacte (138) de sommet de ladite surface externe (114) et contenu dans un plan de projection radiale contenant l'axe central longitudinal (116) de la surface externe (114); et
un concentrateur (136) de rayonnement solaire pour faire converger des rayons solaires vers des faces arrières des cellules solaires bifaciales du premier ensemble (122);
le ballon dirigeable étant **caractérisé en ce que**
le concentrateur (136) de rayonnement solaire est un deuxième ensemble (156) d'au moins un concentrateur local (164, 166, 168, 170, 172 ; 202 ; 302) de rayonnement solaire, dans lequel chaque concentrateur local (164, 166, 168, 170, 172 ; 202 ; 302) est apparié à une ligne correspondante (124, 126, 128, 130, 132 ; 206 ; 304) de cellules solaires, et comporte un réflecteur (174, 176, 178, 180, 182 ; 208 ; 318) dont une première face réfléchissante (212 ; 322) a une surface de forme convexe adaptée pour faire converger du rayonnement solaire vers les faces arrière (220 ; 330) des cellules solaires de la ligne appariée (124, 126, 128, 130, 132 ; 206 ; 304), et dont une deuxième face concave (214 ; 324), arrière de la première face convexe (212 ; 322), est fixée a la surface externe (114) de l'enveloppe externe (108) en suivant le chemin longitudinal surplombé par la ligne correspondante des cellules solaires, et
les première et deuxième faces des concentrateurs locaux (164, 166, 168, 170, 172) de rayonnement solaire sont dimensionnées et disposées entre elles de sorte à laisser les concentrateurs séparées ou adjacents.

2. Ballon dirigeable équipé d'un générateur solaire compact à concentration selon la revendication 1, dans lequel
la géométrie des lignes (124, 126, 128, 130, 132 ; 206 ; 304) des cellules solaires et des faces des concentrateurs locaux (164, 166, 168, 170, 172 ; 202 ; 302) est ajustée de façon à assurer un flux solaire constant et de même intensité indépendant de la position de la cellule solaire photovoltaïque sur la portion de surface externe.

3. Ballon dirigeable équipé d'un générateur solaire compact à concentration selon la revendication 1, dans lequel
chaque cellule bifaciale a une face avant et une face arrière, et
les cellules bifaciales des lignes (124, 126, 128, 130, 132 ; 206 ; 304) du premier ensemble (122) sont disposées en termes de positionnement et d'orientation par rapport à la portion de surface externe du ballon à laquelle les cellules sont fixés de sorte que les normales des faces avant de toutes les cellules solaires pointent vers une même direction d'éclairement prédéterminée par rapport au ballon.

4. Ballon dirigeable équipé d'un générateur solaire compact à concentration selon l'une quelconque des revendications 1 à 3, dans lequel
la surface de la première face convexe réfléchissante de chaque concentrateur local (164, 166, 168, 170, 172 ; 202) comprend une première bande masquée par les cellules solaires de la ligne associée (124, 126, 128, 130, 132 ; 206), des deuxième et troisième bandes actives participant à la concentration du rayonnement solaire,
les première et deuxième bandes actives étant constituées en un matériau réfléchissant vis-à-vis du rayonnement contenu dans les bandes de fréquences intervenant dans la conversion photovoltaïque, et
la première bande masquée étant constituée en un matériau réfléchissant vis-à-vis du rayonnement thermique émis par les cellules photovoltaïques lorsqu'elles sont actives.

5. Ballon dirigeable équipé d'un générateur solaire compact à concentration selon la revendication 4, dans lequel
la surface de la première face convexe réfléchissante de chaque concentrateur local (164, 166, 168, 170, 172 ; 202) est constituée intégralement en un matériau à la fois réfléchissant vis-à-vis du rayonnement contenu dans les bandes de fréquences intervenant dans la conversion photovoltaïque, et réfléchissant vis-à-vis du rayonnement thermique émis par les cellules photovoltaïques et le soleil.

6. Ballon dirigeable équipé d'un générateur solaire compact à concentration selon l'une quelconque des revendications 1 à 5, dans lequel
chaque ligne (124, 126, 128, 130, 132 ; 206) de cellules solaires du premier ensemble est fixé à la portion de surface externe de l'enveloppe externe au travers du concentrateur local associé et d'un pilotis (352) de poteaux (356), interposés et fixés entre la ligne (124, 126, 128, 130, 132 ; 206) des cellules photovoltaïques et le concentrateur local apparié (164, 166, 168, 170, 172 ; 202),
le matériau constituant les poteaux (356) étant rigides, électriquement isolant et peu absorbant vis-à-vis rayonnement solaire.

7. Ballon dirigeable équipé d'un générateur solaire compact à concentration selon l'une quelconque des revendications 1 à 6, dans lequel
Les surfaces des premières faces convexes réfléchissantes ont des contours de coupe transversale longitudinale dont la forme est une portion de conique ou une courbe approchant une portion de conique.

8. Ballon dirigeable équipé d'un générateur solaire compact à concentration selon la revendication 7, dans lequel
Les surfaces des premières faces convexes réfléchissantes ont des contours de coupe transversale longitudinale dont la forme est une succession d'un nombre entier impair N de segments approchant une portion de conique, le nombre entier impair N de segments étant compris de préférence parmi les entiers 3, 5 et 7.

9. Ballon dirigeable équipé d'un générateur solaire compact à concentration selon l'une quelconque des revendications 1 à 8, dans lequel
le rapport de la hauteur de surplomb h des lignes de cellules solaires sur la distance r séparant la portion de surface externe de l'axe central longitudinal de la surface externe est inférieure ou égale à 1/15, de préférence inférieure ou égal à 1/30.

10. Ballon dirigeable équipé d'un générateur solaire compact à concentration selon l'une quelconque des revendications 1 à 9, dans lequel
le générateur solaire compact (104) comprend un nombre entier NL de lignes de cellules solaires et de concentrateurs locaux (302), et
chaque concentrateur local (302) est décomposé en une séquence longitudinal d'un nombre entier T, supérieur ou égal à 2, de tronçons longitudinaux (312) de concentrateur local, appariés soit dans un premier cas à une ligne de droite (304) de cellules solaires de même niveau radial par rapport à l'axe longitudinal, ou dans un deuxième cas à une ligne (304) de cellules solaires segmentée en différents niveaux radiaux par rapport à l'axe longitudinal.

11. Ballon dirigeable équipé d'un générateur solaire compact à concentration selon la revendication 10, dans lequel
chaque tronçon longitudinal (312) comporte un réflecteur élémentaire (318) dont une première face réfléchissante élémentaire (322) a une surface de forme convexe adaptée pour faire converger du rayonnement solaire vers les faces arrière (330) des cellules solaires de la ligne appariée (304) de même niveau longitudinal et dont une deuxième face élémentaire (324), arrière et concave, est fixée a la portion de surface externe de l'enveloppe externe en suivant le chemin longitudinal surplombé par la ligne appariée des cellules solaires.

12. Ballon dirigeable équipé d'un générateur solaire compact à concentration selon la revendication 11, dans lequel
la géométrie des lignes (304) des cellules solaires et des faces (322, 324) des tronçons longitudinaux (312) des concentrateurs locaux (302) est ajustée de façon à assurer un flux solaire constant et de même intensité indépendant de la position de la cellule solaire photovoltaïque sur la portion de surface externe.

13. Ballon dirigeable équipé d'un générateur solaire compact à concentration selon l'une quelconque des revendications 11 à 12, dans lequel
la surface de la première face réfléchissante élémentaire (322) de chaque tronçon (312) de concentrateur local (302) comprend une première bande élémentaire (334) masquée par les cellules solaires de même niveau longitudinal de la ligne appariée, des deuxième et troisième bandes élémentaires actives (336, 338) participant à la concentration du rayonnement solaire,
les première et deuxième bandes élémentaires actives (336, 338) étant constituées en un matériau réfléchissant vis-à-vis du rayonnement contenu dans les bandes de fréquences intervenant dans la conversion photovoltaïque, et
la première bande élémentaire (334) masquée étant constituée en un matériau réfléchissant vis-à-vis du rayonnement thermique émis par les cellules photovoltaïques lorsqu'elles sont actives.

14. Ballon dirigeable équipé d'un générateur solaire compact à concentration selon l'une quelconque des revendications 11 à 13, dans lequel
les surfaces des premières faces élémentaires (322) convexes réfléchissantes ont des contours de coupe transversale longitudinale dont la forme est une portion de conique ou une courbe approchant une portion de conique.

15. Ballon dirigeable équipé d'un générateur solaire compact à concentration selon la revendication 14, dans lequel
les surfaces des premières faces élémentaires convexes (322) réfléchissantes ont des contours de coupe transversale longitudinale dont la forme est une succession d'un nombre entier impair N de segments approchant une portion de conique, le nombre entier impair N de segments étant compris de préférence parmi les entiers 3, 5 et 7.

## Patentansprüche

1. Lenkbarer Ballon, welcher mit einem kompakten Solargenerator mit Konzentration ausgestattet ist, um den Ballon im Flug mit elektrischer Energie anhand von Sonnenstrahlung zu versorgen,
wobei der lenkbare Ballon eine äußere Hülle (108), ein in der äußeren Hülle (108) enthaltenes Trägergas und einen kompakten Solargenerator (104) mit Konzentration beinhaltet,
wobei die äußere Hülle (108) eine äußere, geschlossene Fläche (114) länglicher Form entlang einer vorbestimmten Längsmittelachse (116) besitzt,
wobei der kompakte Solargenerator (104) Folgendes beinhaltet:
eine erste Gruppe (122) aus mindestens einer Reihe (124, 126, 128, 130, 132; 206; 304) von zweiseitigen Photovoltaik-Solarzellen (134), angeordnet oberhalb von und in einer vorbestimmten Höhe h eines kompakten Abschnitts (138) einer Spitze (140) der äußeren Fläche (114), wobei jede Reihe (124, 126, 128, 130, 132; 206; 304) von zweiseitigen Solarzellen konfiguriert ist, um überhängend einem Längsweg (144, 146, 148, 150, 152; 204; 306) zu folgen, der auf dem kompakten Abschnitt (138) einer Spitze der äußeren Fläche (114) trassiert ist und welcher in einer radialen Projektionsebene enthalten ist, welche die Längsmittelachse (116) der äußeren Fläche (114) enthält; und
einen Konzentrator (136) für Sonnenstrahlung, um Sonnenstrahlen auf Rückseiten der zweiseitigen Solarzellen der ersten Gruppe (122) konvergierend auszurichten;
wobei der lenkbare Ballon **dadurch gekennzeichnet ist, dass**
der Konzentrator (136) für Sonnenstrahlung eine zweite Gruppe (156) aus mindestens einem lokalen Konzentrator (164, 166, 168, 170, 172; 202; 302) für Sonnenstrahlung ist, bei welcher jeder lokale Konzentrator (164, 166, 168, 170, 172; 202; 302) mit einer entsprechenden Reihe (124, 126, 128, 130, 132; 206; 304) von Solarzellen gepaart ist, und einen Reflektor (174, 176, 178, 180, 182; 208; 318) beinhaltet, der eine erste reflektierende Seite (212; 322) besitzt, welche eine Fläche konvexer Form besitzt, welche geeignet ist, die Sonnenstrahlung auf die Rückseiten (220; 330) der Solarzellen der gepaarten Reihe (124, 126, 128, 130, 132; 206; 304) konvergierend auszurichten, und der eine zweite konkave Seite (214; 324) besitzt, Rückseite der ersten konvexen Seite (212 ; 322), welche an der äußeren Fläche (114) der äußeren Hülle (108) entlang des von der entsprechenden Reihe von Solarzellen überhangenen länglichen Wegs befestigt ist, und
die erste und die zweite Seite der lokalen Sonnenstrahlungs-Konzentratoren (164, 166, 168, 170, 172) so dimensioniert und untereinander angeordnet sind, dass die Konzentratoren getrennt oder aneinander angrenzend sind.

2. Lenkbarer Ballon, ausgestattet mit einem kompakten Solargenerator mit Konzentration nach Anspruch 1, bei welchem
die Geometrie der Reihen (124, 126, 128, 130, 132; 206; 304) der Solarzellen und der Seiten der lokalen Konzentratoren (164, 166, 168, 170, 172; 202; 302) so angepasst ist, dass ein konstanter solarer Fluss und ein solarer Fluss gleicher Intensität unabhängig von der Position der Photovoltaik-Solarzelle auf dem Abschnitt der äußeren Fläche gewährleistet ist.

3. Lenkbarer Ballon, ausgestattet mit einem kompakten Solargenerator mit Konzentration nach Anspruch 1, bei welchem
jede zweiseitige Zelle eine Vorder- und eine Rückseite besitzt, und
die zweiseitigen Zellen der Reihen (124, 126, 128, 130, 132; 206; 304) der ersten Gruppe (122) in Bezug auf Positionierung und Ausrichtung in Bezug auf den Abschnitt der äußeren Fläche des Ballons, an welcher die Zellen befestigt sind, so angeordnet sind, dass die Normalen der Vorderseiten aller Solarzellen in eine selbe vorbestimmte Beleuchtungsrichtung in Bezug auf den Ballon weisen.

4. Lenkbarer Ballon, ausgestattet mit einem kompakten Solargenerator mit Konzentration nach einem der Ansprüche 1 bis 3, bei welchem
die Fläche der ersten konvexen, reflektierenden Seite jedes lokalen Konzentrators (164, 166, 168, 170, 172; 202) einen ersten durch die Solarzellen der dazugehörigen Reihe (124, 126, 128, 130, 132; 206) verdeckten Streifen beinhaltet, wobei ein zweiter und ein dritter aktive Streifen an der Konzentration der Sonnenstrahlung mitwirken,
wobei der erste und der zweite aktive Streifen aus einem gegenüber der Strahlung, welche in den Frequenzbändern der photovoltaischen Umwandlung enthalten ist, reflektierenden Material bestehen, und
der erste verdeckte Streifen aus einem Material besteht, welches gegenüber der thermischen Strahlung reflektierend ist, welche von den Photovoltaikzellen abgegeben wird, wenn diese aktiv sind.

5. Lenkbarer Ballon, ausgestattet mit einem kompakten Solargenerator mit Konzentration nach Anspruch 4, bei welchem
die Fläche der ersten konvexen, reflektierenden Seite jedes lokalen Konzentrators (164, 166, 168, 170, 172; 202) vollständig aus einem Material besteht, welches gleichzeitig gegenüber der Strahlung reflektierend ist, welche in den bei der photovoltaischen Umwandlung mitwirkenden Frequenzbändern enthalten ist, und gegenüber der thermischen Strahlung reflektierend ist, welche von den Photovoltaikzellen und von der Sonne abgegeben wird.

6. Lenkbarer Ballon, ausgestattet mit einem kompakten Solargenerator mit Konzentration nach einem der Ansprüche 1 bis 5, bei welchem
jede Reihe (124, 126, 128, 130, 132; 206) von Solarzellen der ersten Gruppe an dem Abschnitt der äußeren Fläche der äußeren Hülle über den dazugehörigen lokalen Konzentrator und ein Pfahlwerk (352) aus Pfosten (356) befestigt ist, welche zwischen der Reihe (124, 126, 128, 130, 132; 206) der Photovoltaikzellen und dem gepaarten lokalen Konzentrator (164, 166, 168, 170, 172; 202) zwischengeschaltet und befestigt sind,
wobei das die Pfosten (356) bildende Material starr, elektrisch isolierend und kaum gegenüber der Sonnenstrahlung absorbierend ist.

7. Lenkbarer Ballon, ausgestattet mit einem kompakten Solargenerator mit Konzentration nach einem der Ansprüche 1 bis 6, bei welchem
die Flächen der ersten konvexen, reflektierenden Seiten Längsquerschnittkonturen besitzen, deren Form ein konischer Abschnitt oder eine Kurve ist, welche sich einem konischen Abschnitt annähert.

8. Lenkbarer Ballon, ausgestattet mit einem kompakten Solargenerator mit Konzentration nach Anspruch 7, bei welchem
die Flächen der ersten konvexen, reflektierenden Seiten Längsquerschnittkonturen besitzen, deren Form eine Abfolge einer ungeraden Ganzzahl N von Segmenten ist, welche sich einem konischen Abschnitt annähern, wobei die ungerade Ganzzahl N von Segmenten vorzugsweise in den Ganzzahlen 3, 5 und 7 beinhaltet ist.

9. Lenkbarer Ballon, ausgestattet mit einem kompakten Solargenerator mit Konzentration nach einem der Ansprüche 1 bis 8, bei welchem
das Verhältnis zwischen der Überhangshöhe h der Reihen von Solarzellen und dem Abstand r, welcher den Abschnitt der äußeren Fläche von der Längsmittelachse der äußeren Fläche trennt, kleiner oder gleich 1/15 ist, vorzugsweise kleiner oder gleich 1/30.

10. Lenkbarer Ballon, ausgestattet mit einem kompakten Solargenerator mit Konzentration nach einem der Ansprüche 1 bis 9, bei welchem
der kompakte Solargenerator (104) eine Ganzzahl NL von Reihen von Solarzellen und von lokalen Konzentratoren (302) beinhaltet, und
jeder lokale Konzentrator (302) sich in eine Längssequenz einer Ganzzahl T, die größer oder gleich 2 ist, von Längsabschnitten (312) eines lokalen Konzentrators gliedert, welche in einem ersten Fall mit einer geraden Reihe (304) von Solarzellen gleicher radialer Stufe in Bezug auf die Längsachse, oder in einem zweiten Fall, mit einer Reihe (304) von Solarzellen, welche in unterschiedliche radiale Stufen in Bezug auf die Längsachse segmentiert ist, gepaart sind.

11. Lenkbarer Ballon, ausgestattet mit einem kompakten Solargenerator mit Konzentration nach Anspruch 10, bei welchem
jeder Längsabschnitt (312) einen Elementarreflektor (318) beinhaltet, der eine erste reflektierende Elementarseite (322) besitzt, welche eine Fläche konvexer Form besitzt, welche geeignet ist, die Sonnenstrahlung auf die Rückseiten (330) der Solarzellen der gepaarten Reihe (304) gleicher Längsstufe konvergierend auszurichten, und der eine zweite Elementarseite (324) besitzt, Rückseite der zweiten Elementarseite und konkav, welche an dem Abschnitt der äußeren Fläche der äußeren Hülle entlang des von der gepaarten Reihe von Solarzellen überhangenen Wegs befestigt ist.

12. Lenkbarer Ballon, ausgestattet mit einem kompakten Solargenerator mit Konzentration nach Anspruch 11, bei welchem
die Geometrie der Reihen (304) der Solarzellen und der Seiten (322, 324) der Längsabschnitte (312) der lokalen Konzentratoren (302) so angepasst ist, dass ein konstanter solarer Fluss und ein solarer Fluss gleicher Intensität unabhängig von der Position der Photovoltaik-Solarzelle auf dem Abschnitt der äußeren Fläche gewährleistet ist.

13. Lenkbarer Ballon, ausgestattet mit einem kompakten Solargenerator mit Konzentration nach einem der Ansprüche 11 bis 12, bei welchem
die Fläche der ersten reflektierenden Elementarseite (322) jedes Abschnitts (312) eines lokalen Konzentrators (302) einen ersten Elementarstreifen (334) beinhaltet, welcher von den Solarzellen gleicher Längsstufe der gepaarten Linie verdeckt wird, wobei ein zweiter und ein dritter aktiver Elementarstreifen (336, 338) an der Konzentration der Sonnenstrahlung mitwirken,
wobei der erste und der zweite aktive Elementarstreifen (336, 338) aus einem gegenüber der Strahlung, welche in den bei der photovoltaischen Umwandlung mitwirkenden Frequenzbändern enthalten ist, reflektierenden Material bestehen, und
der erste verdeckte Elementarstreifen (334) aus einem Material besteht, welches gegenüber der thermischen Strahlung reflektierend ist, welche von den Photovoltaikzellen abgegeben wird, wenn diese aktiv sind.

14. Lenkbarer Ballon, ausgestattet mit einem kompakten Solargenerator mit Konzentration nach einem der Ansprüche 11 bis 13, bei welchem
die Flächen der ersten konvexen, reflektierenden Elementarseiten (322) Längsquerschnittkonturen besitzen, deren Form ein konischer Abschnitt oder eine Kurve ist, welche sich einem konischen Abschnitt annähert.

15. Lenkbarer Ballon, ausgestattet mit einem kompakten Solargenerator mit Konzentration nach Anspruch 14, bei welchem
die Flächen der ersten konvexen, reflektierenden Elementarseiten (322) Längsquerschnittkonturen besitzen, deren Form eine Abfolge einer ungeraden Ganzzahl N von Segmenten ist, welche sich einem konischen Abschnitt annähern, wobei die ungerade Ganzzahl N von Segmenten vorzugsweise in den Ganzzahlen 3, 5 und 7 beinhaltet ist.

## Claims

1. Airship equipped with a compact solar generator with concentration in order to supply said airship in flight with electrical energy using solar radiation,
the airship comprising an outer envelope (108), a bearer gas contained in the outer envelope (108), and a compact solar generator (104) with concentration,
the outer envelope (108) having an closed outer surface (114) of elongate form along a predetermined longitudinal central axis (116),
the compact solar generator (104) containing
a first set (122) of at least one row (124, 126, 128, 130, 132; 206; 304) of bifacial photovoltaic solar cells (134), arranged above and at a predetermined height h from a compact portion (138) of apex (140) of the outer surface (114), in which each row (124, 126, 128, 130, 132; 206; 304) of bifacial solar cells is configured to follow, overhanging, a longitudinal path (144, 146, 148, 150, 152; 204; 306), plotted on the compact portion (138) of apex of said outer surface (114) and contained in a radial projection plane containing the longitudinal central axis (116) of the outer surface (114); and
a solar radiation concentrator (136) for converging solar rays towards rear faces of the bifacial solar cells of the first set (122);
the airship being **characterized in that**
the solar radiation concentrator (136) is a second set (156) of at least one local solar radiation concentrator (164, 166, 168, 170; 172, 202; 302), in which each local concentrator (164, 166, 168, 170; 172, 202; 302) is paired with a corresponding row (124, 126, 128, 130, 132; 206; 304) of solar cells, and comprises a reflector (174, 176, 178, 180, 182; 208; 318) of which a first reflecting face (212; 322) has a surface of convex form suitable for making solar radiation converge towards the rear faces (220; 330) of the solar cells of the paired row (124, 126, 128, 130, 132; 206; 304), and of which a second concave face (214; 324), behind the first convex face (212; 322), is fixed to the outer surface (114) of the outer envelope (108) along the longitudinal path overhung by the corresponding row of solar cells, and
the first and second faces of the local solar radiation concentrators (164, 166, 168, 170, 172) are dimensioned and arranged between them so as to leave the concentrators separate or adjacent.

2. Airship equipped with a compact solar generator with concentration according to claim 1, wherein
the geometry of the rows (124, 126, 128, 130, 132; 206; 304) of the solar cells and of the faces of the local concentrators (164, 166, 168, 170; 172, 202; 302) is adjusted so as to ensure a solar flux that is constant and of the same intensity independent of the position of the photovoltaic solar cell on the portion of outer surface.

3. Airship equipped with a compact solar generator with concentration according to claim 1, wherein
each bifacial cell has a front face and a rear face, and
the bifacial cells of the rows (124, 126, 128, 130, 132; 206; 304) of the first set (122) are arranged in terms of positioning and of orientation relative to the portion of outer surface of the airship on which the cells are fixed such that the normals of the front faces of all the solar cells point towards a same predetermined direction of illumination relative to the airship.

4. Airship equipped with a compact solar generator with concentration according to any of claims 1 to 3, wherein
the surface of the first reflecting convex face of each local concentrator (164, 166, 168, 170, 172, 202) comprises a first strip masked by the solar cells of the associated row (124, 126, 128, 130, 132; 206), second and third active strips participating in the concentration of the solar radiation,
the first and second active strips consisting of a material that is reflective to the radiation contained in the frequency bands involved in the photovoltaic conversion, and
the first masked strip consisting of a material that is reflective to the thermal radiation emitted by the photovoltaic cells when they are active.

5. Airship equipped with a compact solar generator with concentration according to claim 4, wherein
the surface of the first reflecting convex face of each local concentrator (164, 166, 168, 170, 172; 202) is made entirely of a material that is both reflective to the radiation contained in the frequency bands involved in the photovoltaic conversion, and reflective to the thermal radiation emitted by the photovoltaic cells and the sun.

6. Airship equipped with a compact solar generator with concentration according to any of claims 1 to 5, wherein
each row (124, 126, 128, 130, 132; 206) of solar cells of the first set is fixed to the portion of outer surface of the outer envelope through the associated local concentrator and a pile work (352) of posts (356), interposed and fixed between the row (124, 126, 128, 130, 132; 206) of the photovoltaic cells and the paired local concentrator (164, 166, 168, 170, 172; 202),
the material forming the posts (356) being rigid, electrically insulating and with low absorbance to solar radiation.

7. Airship equipped with a compact solar generator with concentration according to any of claims 1 to 6, wherein
the surfaces of the first reflecting convex faces have outlines of longitudinal cross section with the form of a conical portion or a curve approximating a conical portion.

8. Airship equipped with a compact solar generator with concentration according to claim 7, wherein
the surfaces of the first reflecting convex faces have outlines of longitudinal cross section in the form of a succession of an odd integer number N of segments approximating a conical portion, the odd integer number N of segments preferably being included in the integers 3, 5 and 7.

9. Airship equipped with a compact solar generator with concentration according to any of claims 1 to 8, wherein
the ratio of the height of overhang h of the rows of solar cells to the distance r separating the portion of outer surface of the longitudinal central axis of the outer surface is less than or equal to 1/15, preferably less than or equal to 1/30.

10. Airship equipped with a compact solar generator with concentration according to any of claims 1 to 9, wherein
the compact solar generator (104) comprises an integer number NL of rows of solar cells and of local concentrators (302), and
each local concentrator (302) is subdivided into a longitudinal sequence of an integer number T, greater than or equal to 2, of longitudinal sections (312) of local concentrator, paired either in a first case with a straight row (304) of solar cells of same radial level relative to the longitudinal axis, or in a second case to a row (304) of solar cells segmented into different radial levels relative to the longitudinal axis.

11. Airship equipped with a compact solar generator with concentration according to claim 10, wherein
each longitudinal section (312) comprises an elementary reflector (318) of which a first elementary reflecting face (322) has a surface of convex form suitable for making the solar radiation converge towards the rear faces (330) of the solar cells of the paired row (304) of same longitudinal level and of which a second elementary face (324), rear and concave, is fixed to the portion of outer surface of the outer envelope along the longitudinal path overhung by the paired row of solar cells.

12. Airship equipped with a compact solar generator with concentration according to claim 11, wherein
the geometry of the rows (304) of solar cells and of the faces (322, 324) of the longitudinal sections (312) of the local concentrators (302) is adjusted so as to ensure a solar flux that is constant and of same intensity independent of the position of the photovoltaic solar cell on the portion of outer surface.

13. Airship equipped with a compact solar generator with concentration according to any of claims 11 to 12, wherein
the surface of the first elementary reflecting face (322) of each section (312) of local concentrator (302) comprises a first elementary strip (334) masked by the solar cells of same longitudinal level of the paired row, second and third active elementary strips (336, 338) participating in the concentration of the solar radiation,
the first and second active elementary strips (336, 338) being made of a material reflective to the radiation contained in the frequency bands involved in the photovoltaic conversion, and
the first masked elementary strip (334) being made of a material reflective to the thermal radiation emitted by the photovoltaic cells when they are active.

14. Airship equipped with a compact solar generator with concentration according to any of claims 11 to 13, wherein
the surfaces of the first reflecting convex elementary faces (322) have outlines of longitudinal cross section in the form of a conical portion or a curve approximating a conical portion.

15. Airship equipped with a compact solar generator with concentration according to claim 14, wherein
the surfaces of the first reflecting convex elementary faces (322) have outlines of longitudinal cross section in the form of a succession of an odd integer number N of segments approximating a conical portion, the odd integer number N of segments preferably being included in the integers 3, 5 and 7.
